# EUROPEAN PATENT APPLICATION

(11) **EP 2 484 724 A1**
(43) Date of publication of application: **08.08.2012**
(21) Application number: 10820530.3
(22) Date of filing: 28.09.2010
(51) Int. Cl.: C08L 63/00, B32B 27/38, C08G 59/62, C08J 7/04, C08K 3/00, C08K 5/54, C09J 7/02, C09J 11/04, C09J 177/00, C09J 179/08, B32B 15/088, B32B 15/092

(54) **MULTILAYER RESIN SHEET AND METHOD FOR PRODUCING SAME, METHOD FOR PRODUCING MULTILAYER RESIN SHEET CURED PRODUCT, AND HIGHLY THERMALLY CONDUCTIVE RESIN SHEET LAMINATE AND METHOD FOR PRODUCING SAME**

(30) Priority: 29.09.2009 JP 2009224333
(71) Applicant: Hitachi Chemical Company, Ltd., Tokyo 163-0449 (JP)
(72) Inventor: KATAGI, Hideyuki, Tsukuba-shi Ibaraki 300-4247 (JP); TAKEZAWA, Yoshitaka, Tsukuba-shi Ibaraki 300-4247 (JP); NISHIYAMA, Tomoo, Tsukuba-shi Ibaraki 300-4247 (JP); HARA, Naoki, Hitachi-shi Ibaraki 317-8555 (JP); TANAKA, Hiroyuki, Hitachi-shi Ibaraki 317-8555 (JP); YOSHIHARA, Kensuke, Hitachi-shi Ibaraki 317-8555 (JP); JOUMEN, Masayoshi, Chikusei-shi Ibaraki 308-8524 (JP); TAKAHASHI, Hiroyuki, Tsukuba-shi Ibaraki 300-4247 (JP)
(74) Representative: HOFFMANN EITLE
(86) International application number: PCT/JP2010/066861
(87) International publication number: WO 2011/040415

(57) **Abstract**

A multilayer resin sheet is constituted by including a resin layer containing an epoxy resin having a mesogenic skeleton, a curing agent and an inorganic filler, and an insulating adhesive layer formed on at least either of the surfaces of the resin layer.

A cured multilayer resin sheet originated from the multilayer resin sheet has high thermal conductivity, good insulation and adhesive strength, and, further, superior thermal shock resistance, and is suitable as an electric insulating material to be used for an electric or electronic device.

## Description

### [Technical Field]

The present invention relates to a multilayer resin sheet and a method for producing the same, a method for producing a cured multilayer resin sheet, and a highly thermally conductive resin sheet laminate and a method for producing the same.

### [Background Art]

For electric and electronic devices, such as a motor, a generator, as well as a printed circuit board and an IC chip, a heat generation value from a conductor has been growing further according to densification in step with the progress of miniaturization, and superior heat radiating ability of an insulating material has been demanded.

As an insulating material inorganic ceramics and organic materials have been broadly utilized. An inorganic ceramic has high thermal conductivity but is expensive, and its insulation property is inferior to an organic material. On the other hand, an organic material has a quite good insulation property, but its thermal conductivity is low. As a material having both insulating ability and thermal conductivity compatibly, a composite material of an organic material loaded with a filler having a high thermal conductivity has been expected.

Japanese Patent Laid-Open No. 2008-13759 discloses that a composite of a general bisphenol A epoxy resin and an oxidized alumina filler has thermal conductivity of 3.8 W/mK. (xenon flash lamp method). It discloses further that a composite of a liquid crystalline epoxy resin having a mesogenic skeleton and an alumina filler has thermal conductivity of 9.4 W/mK (xenon flash lamp method).
Further, Japanese Patent No. 4118691 discloses that a cured resin out of an epoxy resin having a mesogenic skeleton and a curing agent for an epoxy resin exhibits high thermal conductivity, and by containing a filler powder it exhibits higher thermal conductivity.

### [Disclosure of Invention]

### [Problems to be Solved by the Invention]

The heretofore known examples of an organic-inorganic composite sheet (hereinafter abbreviated as a "resin sheet") are remarkable in terms of their superior thermal conductivity, however it would probably be difficult to adapt them to a process which should utilize them practically. More particularly, such a resin sheet is generally required to have high adhesiveness to a metal surface, such as aluminium and copper, or an organic material surface. However, in order to exhibit thermal conductivity an inorganic filler component should be in general highly loaded, which induces decrease in adhesive strength of a resin component, and there appears occasionally a problem that delamination may take place by a thermal shock on occasion of reflow or thermal cycling. Because of such a problem, a resin sheet based on a highly loaded filler has not yet been commercialized until now.

An object of the present invention is, solving the problem, to provide a multilayer resin sheet able to constitute a cured multilayer resin sheet, which is suitable as an electric insulating material to be used for an electric or electronic device, having high thermal conductivity, good insulation and adhesive strength, and, further, superior thermal shock resistance; a method for producing the same; a method for producing the cured multilayer resin sheet; and a highly thermally conductive resin sheet laminate; and a method for producing the same.

### [Means for Solving the Problems]

The inventors studied intensively for attaining the object to discover a highly thermally conductive resin sheet with high adhesion reliability, which does not cause delamination even through a thermal shock test of reflow or thermal cycling, by providing layers for imparting adhesiveness on either or both surfaces of a resin sheet with high thermal conductivity. It becomes possible by utilizing a polyimide resin or a polyamide imide resin as a resin to be used in an insulating adhesive layer to improve the adhesive strength as well as the insulation and the thermal stability. Further, by adding a filler with high thermal conductivity, such as aluminium oxide, magnesium oxide, aluminum nitride, boron nitride, or silicon nitride, to the insulating adhesive layer, it becomes possible to impart high thermal conductivity to the insulating adhesive layer itself, which may constitute thermal resistance, thereby obtaining a resin sheet having superior thermal conductivity even in a constitution combining a resin sheet layer and an insulating adhesive layer.

A 1 st aspect of the present invention is a multilayer resin sheet including a resin layer containing an epoxy resin having a mesogenic skeleton, a curing agent and an inorganic filler, and an insulating adhesive layer provided on at least one surface of the resin layer.

Preferably, the insulating adhesive layer comprises at least one selected from the group consisting of a polyamide resin, a polyamide imide resin and a modified polyamide imide resin. Further, the insulating adhesive layer preferably further comprises an inorganic filler from the standpoint of a heat radiating property.

Preferably, the curing agent is a phenolic novolac resin, and more preferably, the phenolic novolac resin comprises a phenolic novolac resin linking, with a methylene chain, a phenolic compound selected from a monofunctional phenol and a bifunctional phenol. Further, it is also preferable that the phenolic novolac resin comprises a catechol resorcinol novolac resin.

Preferably, the resin layer further comprises a binder agent, and more preferably, the binder agent is a silane coupling agent.

Preferably, a planar structure of the mesogen ic skeleton has an asymmetric structure, and more preferably, the mesogenic skeleton has a structure in which 2 bivalent functional groups derived from benzene are bonded through a bivalent linking group.

Preferably, a particle size distribution curve of the inorganic filler has at least 2 peaks from the standpoint of imparting a better filling rate, fluidity, and thermal conductivity. Further, a density of the resin layer is preferably from 3.00 to 3.30 g/cm³.

A 2nd aspect of the present invention is a highly thermally conductive resin sheet laminate including a cured multilayer resin sheet obtained by curing the multilayer resin sheet and metal plates or radiator plates placed on both surfaces of the cured multilayer resin sheet.

A 3rd aspect of the present invention is a method for producing a multilayer resin sheet including a resin layer formation step, in which a resin layer is yielded by forming a resin composition containing an epoxy resin having a mesogenic skeleton, a curing agent and an inorganic filler into a sheet, and an adhesive layer formation step, in which an insulating adhesive layer is provided on at least one surface of the resin layer.

A 4th aspect of the present invention is a method for producing a cured multilayer resin sheet including a curing step, in which the multilayer resin sheet is subjected to light or heat to cure the resin layer.

A 5th aspect of the present invention is a method for producing a highly thermally conductive resin sheet laminate including a step for placing a metal plate or a radiator plate on the insulating adhesive layer of the multilayer resin sheet, and a curing step, in which the multilayer resin sheet is subjected to light or heat to cure the resin layer.

### [Effects of the Invention]

According to the present invention, a multilayer resin sheet able to constitute a cured multilayer resin sheet, which is suitable as an electric insulating material, to be used for an electric or electronic device, having high thermal conductivity, good insulation and adhesive strength, and, further, superior thermal shock resistance; a method for producing the same; a method for producing the cured multilayer resin sheet; as well as a highly thermally conductive resin sheet laminate; and a method for producing the same can be provided.

### [Brief Description of Drawings]

[Figure 1] Figure 1 is a schematic cross-sectional view showing an example of a constitution of a power semiconductor device constituted with a multilayer resin sheet according to the present invention;
[Figure 2] Figure 2 is a schematic cross-sectional view showing an example of a constitution of a power semiconductor device constituted with a multilayer resin sheet according to the present invention;
[Figure 3] Figure 3 is a schematic cross-sectional view showing an example of a constitution of a power semiconductor device constituted with a multilayer resin sheet according to the present invention;
[Figure 4] Figure 4 is a schematic cross-sectional view showing an example of a constitution of an LED light bar constituted with a multilayer resin sheet according to the present invention;
[Figure 5] Figure 5 is a schematic cross-sectional view showing an example of a constitution of an LED bulb constituted with a multilayer resin sheet according to the present invention;
[Figure 6] Figure 6 is a schematic cross-sectional view showing an example of a constitution of an LED bulb constituted with a multilayer resin sheet according to the present invention; and
[Figure 7] Figure 7 is a schematic cross-sectional view showing an example of a constitution of an LED substrate constituted with a multilayer resin sheet according to the present invention.

### [Best mode for Carrying Out the Invention]

### <Multilayer resin sheet>

A multilayer resin sheet according to the present invention is characterized by including a resin layer containing an epoxy resin having a mesogenic skeleton, a curing agent and an inorganic filler, and an insulating adhesive layer formed on at least either of the surfaces of the resin layer.
In this connection an insulating adhesive layer may be also referred to as an insulation adhesive layer.

### Insulating adhesive layer

There is no particular restriction on the insulating adhesive layer, insofar as it is electrically insulating and able to bond the resin layer with a substrate, and it is preferably constituted by containing at least one selected from a polyimide resin, a polyamide imide resin and a modified polyamide imide resin, from an aspect of its electrical insulation and adhesiveness, and according to need also another component.
The insulation means herein the insulation breakdown voltage is 2 kV or higher, preferably 2.5 kV or higher, and more preferably 3 kV or higher.
Further, according to the present invention an insulating adhesive layer is provided on at least one surface of a resin layer, and preferably provided on both the surfaces of the resin layer from an aspect of the thermal stability.

Representative examples of a polyimide resin product to be used for an insulating adhesive layer of a multilayer resin sheet according to the present invention include Upicoat FS-100L (by Ube Industries, Ltd.), Semicofine SP-300, SP-400, SP-800 (by Toray Industries, Inc.), and U Imide series (by Unitika Ltd.). Examples of a polyamide imide resin and a modified polyamide imide resin include Vylomax series (by Toyobo Co., Ltd.), Torlon (by Solvay Advanced Polymers K.K), and KS series (by Hitachi Chemical Co., Ltd.).
Among them from viewpoints of high thermal stability, and high adhesiveness, the use of a modified polyamide imide resin represented by KS series (by Hitachi Chemical Co., Ltd.) is preferable.

The resins are usually in a form of a varnish, in which a resin is dissolved in a solvent, and can be applied directly on a PET film or an adherend to form a film for use by evaporating the solvent. Alternatively, the resin subjected to solvent evaporation in advance to a film state can be utilized as it is.

A multilayer resin sheet according to the present invention is characterized by being constituted by forming an insulating adhesive layer on either or both the surfaces of the resin layer (hereinafter also referred to as a "resin sheet"). Examples of a method for forming an insulating adhesive layer include a method of combining a resin sheet and an insulating adhesive layer formed to a film by means of pressing or laminating; and a method of applying directly the resin varnish on to a resin sheet surface and evaporating a solvent. From an aspect of workability, and the like, a method of preparing in advance a film of an insulating adhesive layer and laminating it to a resin sheet is preferable.

The polyimide resin, the polyamide imide resin and the modified polyamide imide resin to be used in an insulating adhesive layer of a multilayer resin sheet according to the present invention may be used singly, or used also in a combination of 2 or more types thereof.
The content in an insulating adhesive layer is preferably 1 to 99 % by mass, more preferably 3 to 70 % by mass, and further preferably 5 to 50 % by mass. If the amount of a resin component in an insulating adhesive layer is 99 % by mass or less, the thermal conductivity tends to be better. Meanwhile, if the amount of a resin component is 1 % by mass or more, the adhesive strength is better and the thermal shock resistance tends to be better.

Preferably, the insulating adhesive layer contains additionally at least one inorganic filler.
Examples of an electrically nonconductive inorganic filler to be contained in the insulating adhesive layer include aluminium oxide, magnesium oxide, aluminum nitride, boron nitride, silicon nitride, silicon oxide, aluminium hydroxide, and barium sulfate. Examples of an electrically conductive filler include carbon, gold, silver, nickel, and copper. The inorganic fillers may be used singly, or in a combination of 2 or more types thereof.
By using an electrically nonconductive filler, a multilayer resin sheet with improved insulation can be obtained. Meanwhile, by using an electrically conductive filler, a multilayer resin sheet with improved thermal conductivity can be obtained.

The applicable content of an inorganic filler based on the total mass of the insulating adhesive layer as 100 % by mass is in a range of 0 to 99 % by mass, preferably 30 to 97 % by mass, and more preferably 50 to 95 % by mass. If the content of an inorganic filler is lower, the adhesive strength improves, and the thermal shock resistance tends to improve. Meanwhile, if the content of an inorganic filler is higher the thermal conductivity tends to improve.

It is preferable that the insulating adhesive layer contains further a thermosetting resin with a functional group, which is able to react with an amide group in a resin skeleton to be used in an insulating adhesive layer. Examples of the thermosetting resin with a functional group include an epoxy resin, a phenol resin, and a cresol novolac resin. Among them, from an aspect of a handling property, an epoxy resin is preferable. As an epoxy resin commercially available products can be generally used, and epoxy resins containing a phosphorus atom in the molecule are preferable from viewpoints of adhesiveness and flexibility. They may be used singly, or in a combination of 2 or more types thereof.

The amount of an added thermosetting resin with a functional group which is able to react with an amide group in a resin skeleton to be used in an insulating adhesive layer is preferably 5 to 100 parts by mass based on 100 parts by mass of the resin used in the insulating adhesive layer, more preferably 10 to 80 parts by mass, and especially preferably 20 to 65 parts by mass. If the amount is 5 parts by mass or more, adequate curing function tends to be obtained. Meanwhile, if the amount is 100 parts by mass or less, there is tendency that fragility caused by too high crosslink density of the cured resin, which induces decrease in the adhesive strength, can be inhibited.

Preferably, the insulating adhesive layer contains further a curing agent. There is no particular restriction on a curing agent, insofar as it reacts with an epoxy resin, or promotes a curing reaction between a resin used in the insulating adhesive layer and the thermosetting resin. Specific examples include amines and imidazoles. They may be used singly, or in a combination of 2 or more types thereof. Examples of the amines include dicyandiamide, diaminodiphenylmethane, and guanylurea, and they may be used singly, or in a combination of 2 or more types thereof. Examples of the imidazoles include an alkyl-substituted imidazole such as 2-ethyl-4-methylimidazole and benzoimidazole, and they may be used singly, or in a combination of 2 or more types thereof.

As for the content of the curing agent, if the curing agent is an amine, it should preferably be so added that the equivalent of active hydrogen of an amine (the amine equivalent) nearly equals the epoxy equivalent of an epoxy resin. If the curing agent is an imidazole, the content is preferably 0.1 to 2.0 parts by mass based on 100 parts by mass of the epoxy resin. If the content is 0.1 part by mass or higher, the curability improves and the glass transition temperature after curing tends to become higher. Meanwhile, if the content is 2.0 parts by mass or less, the storage stability and the insulation tend to improve.

There is no particular restriction on the thickness of the insulating adhesive layer, and it may be selected appropriately according to a purpose. From viewpoints of adhesiveness and thermal conductivity, it is preferably 3 to 25 µm and more preferably 3 to 12 µm. Further, from viewpoints of adhesiveness and thermal conductivity, the ratio of the thickness of the insulating adhesive layer to the thickness of a resin sheet (insulating adhesive layer/resin sheet) is preferably from 0.03 to 0.3, and more preferably from 0.03 to 0.2.

The insulating adhesive layer contains preferably at least one selected from a polyamide resin, a polyamide imide resin and a modified polyamide imide resin at the content of 3 to 70 % by mass in the insulating adhesive layer, and at least one inorganic filler selected from aluminium oxide, magnesium oxide, aluminum nitride, boron nitride, silicon nitride, silicon oxide, aluminium hydroxide, barium sulfate, carbon, gold, silver, nickel, and copper at the content of 30 to 97 % by mass in the insulating adhesive layer; and more preferably contains at least one selected from a polyamide imide resin and modified polyamide imide resin at the content of 5 to 50 % by mass in the insulating adhesive layer, and at least one inorganic filler selected from aluminium oxide, boron nitride, and silicon oxide at the content of 50 to 95 % by mass in the insulating adhesive layer.

### Resin layer

A resin layer according to the present invention contains at least one epoxy resin having a mesogenic skeleton. From an aspect of attaining high thermal conductivity, the epoxy resin having a mesogenic skeleton has preferably a mesogenic skeleton in an epoxy resin skeleton, and forms a higher order structure during curing. Specific features of an epoxy resin having a mesogenic skeleton are described, for example, in Japanese Patent No. 4118691. Further, an epoxy resin having a mesogenic skeleton to be used may be a commercially available product, or may be produced newly.

The mesogenic skeleton means a functional group which promotes development of liquid crystallinity or crystallinity by means of intermolecular interaction. Representative specific examples include a biphenyl group, a phenyl benzoate group, an azobenzene group, a stilbene group, and a derivative thereof. Examples of an epoxy resin (a prepolymer) having a mesogenic skeleton include 4-(oxiranylmethoxy)benzoic acid-4,4'-[1,8-octanediylbis(oxy)]bisphenol ester, 4-(oxiranylmethoxy)benzoic acid-4,4'-[1,6-hexanediylbis(oxy)]bisphenol ester, 4-(oxiranylmethoxy)benzoic acid-4,4'-[1,4-butanediylbis(oxy)]bisphenol ester, 4-(4-oxiranylbutoxy)benzoic acid-1,4'-phenylene ester, 4,4'-biphenol diglycidyl ether, 3,3',5,5'-tetramethyl-4,4-biphenol diglycidyl ether, 2,6-bis[4-[4-[2-(oxiranylmethoxy)ethoxy]phenyl]phenoxy]pyridine, and 1-{(3-methyl-4-oxiranylmethoxy)phenyl}-4-(4-oxiranylmethoxyphenyl)-1-cyclohexene.

As for an epoxy resin having a mesogenic skeleton, the planar structure of a mesogenic skeleton is preferably an asymmetric structure, and more preferably a mesogenic skeleton is further a bivalent functional group derived from benzene, and is a structure, in which 2 bivalent functional groups with mutually different structures are bonded through a bivalent linking group.
In this regard, a planar structure with an asymmetric structure means that the structural formula of a mesogenic skeleton is asymmetric, if the structural formula is drawn on a plane.
Specific examples of the epoxy resin having a mesogenic skeleton with an asymmetric structure include 1-{(3-methyl-4-oxiranylmethoxy)phenyl}-4-(4-oxiranylmethoxyphenyl)-1-cyclohexene.

The higher order structure means a structure with microscopic alignment, and a crystal phase or a liquid crystal phase is an example. The existence of such a higher order structure can be easily determined by observation with a polarization microscope. Namely, by observation at a normal condition by means of a crossed nicols method, it can be distinguished by appearance of interference fringes due to a depolarization phenomenon. A higher order structure exists in a resin usually as an island, and refers to each island which has constructed a domain structure. The higher order structure owns a covalent bond.

Specific examples of an epoxy resin developing such a higher order structure include a bicyclic epoxy resin, such as YL-6121H (by Mitsubishi Chemical Corporation), YX-4000H (by Mitsubishi Chemical Corporation), and YSLV-80XY (by Nippon Steel Chemical Co., Ltd.); a tricyclic epoxy resin, such as 1-{(3-methyl-4-oxiranylmethoxy)phenyl}-4-(4-oxiranylmethoxyphenyl)-1-cyclohexene. Further, the examples include a polycyclic epoxy resin, such as 4-(oxiranylmethoxy)benzoic acid-4,4'-[1,8-octanediylbis(oxy)]bisphenol ester, 2,6-bis[4-[4-[2-(oxiranylmethoxy)ethoxy]phenyl]phenoxy]pyridine.
According to the present invention for exhibiting good handling property and high thermal conductivity, 1-{(3-methyl-4-oxiranylmethoxy)phenyl}-4-(4-oxiranylmethoxyphenyl)-1-cyclohexene, 4-(oxiranylmethoxy)benzoic acid-4,4'-[1,8-octanediylbis(oxy)]bisphenol ester, 2,6-bis[4-[4-[2-(oxiranylmethoxy)ethoxy]phenyl]phenoxy]pyridine, and the like, are preferable.

There is no particular restriction on the content of an epoxy resin having a mesogenic skeleton in the resin layer. From viewpoints of thermal conductivity and thermal stability, the content with respect to the solid component in the resin layer is preferably 19 to 30 % by volume, and more preferably 24 to 30 % by volume.
In this connection, the solid component in a resin layer means the residual component after removing volatile components from components constituting the resin layer.

### The resin layer contains at least one curing agent.

Selection of a curing agent to be used for curing an epoxy resin is important in order to develop a higher order structure and to attain high thermal conductivity. More specifically, a polyaddition type curing agent, such as an acid anhydride curing agent, an amine curing agent, a phenol curing agent, and a mercaptan curing agent; as well as a latent curing agent, such as imidazole can be utilized. From viewpoints of thermal stability, and adherence, the use of an amine curing agent and a phenol curing agent is preferable. Further, from an aspect of preservation stability, the use of a phenol curing agent is more preferable.

There is no particular restriction on the amine curing agent, and a commercial product can be used usually. Among others those having 2 functional groups or even more functional groups are preferable for improve cured product properties. Further, from an aspect of thermal conductivity, a polyfunctional curing agent having a rigid skeleton is more preferable.
Examples of a bifunctional amine curing agent include 4,4'-diaminodiphenylmethane, 4,4'-diaminodiphenyl ether, 4,4'-diaminodiphenylsulfon, 4,4'-diamino-3,3'-dimethoxybiphenyl, 4,4'-diaminophenylbenzoate, 1,5-diaminonaphthalene, 1,3-diaminonaphthalene, 1,4-diaminonaphthalene, and 1,8-diaminonaphthalene. Among them, 1,5-diaminonaphthalene is preferable as an amine curing agent, which exhibits high thermal conductivity in a combination with the epoxy resin having a mesogenic skeleton 1-{(3-methyl-4-oxiranylmethoxy)phenyl}-4-(4-oxiranylmethoxyphenyl)-1-cyclohexene.

As the phenol curing agent, a commercially available low molecular weight phenols or a novolac phenol resin therefrom can be used. Examples of an applicable low molecular weight phenol curing agent include a monofunctional curing agent, such as phenol, o-cresol, m-cresol, and p-cresol; a bifunctional curing agent, such as catechol, resorcinol, and hydroquinone; and further a trifunctional curing agent, such as 1,2,3-trihydroxybenzene, 1,2,4-trihydroxybenzene, and 1,3,5-trihydroxybenzene. Further, a phenolic novolac resin, linking the above low molecular weight phenols by a methylene chain, can be used as a curing agent.
A phenol curing agent according to the present invention contains preferably at least one phenolic novolac resin, which links 2 or more phenol compounds selected out of monofunctional phenols and bifunctional phenols by a methylene chain, from an aspect of thermal conductivity.

Further, to improve the thermal conductivity, as a phenol curing agent developing high thermal conductivity, the use of a bifunctional phenol compound, such as catechol, resorcinol as well as hydroquinone, as a curing agent is preferable. In this regard, to improve further the thermal stability, the use of a phenol novolac curing agent linking the bifunctional phenol compounds by a methylene chain is more preferable.
More specifically, a novolac resin of a single phenolic, such as a catechol novolac resin, a resorcinol novolac resin, and a hydroquinone novolac resin, and a novolac resin of 2 or more phenolics, such as a catechol resorcinol novolac resin, and a resorcinol hydroquinone novolac resin, can be used. Among them, from an aspect of thermal conductivity, the phenol curing agent contains preferably at least one type of catechol resorcinol novolac resins.

The phenolic novolac resin may contain a monomer phenolic compound constituting a phenolic novolac resin. There is no particular restriction on the content (by percentage) of a monomer phenolic compound constituting a phenolic novolac resin (hereinafter occasionally referred to as "monomer content"), and it is preferably 5 to 50 % by mass, more preferably 10 to 45 % by mass, and further preferably 15 to 35 % by mass.

If the monomer content is 5 % by mass or higher, the adherence of an inorganic filler improves, by inhibiting viscosity increase of a novolac resin. While, if it is 50 % by mass or less, superior thermal conductivity and thermal stability can be attained, by forming higher order structures at a higher density by a crosslinking reaction during curing.

The content ratio of the epoxy resin to the phenol curing agent (epoxy resin/phenol curing agent) based on epoxy equivalent is preferably from 0.85 to 1.2, and more preferably from 0.9 to 1.1, from an aspect of reactivity, thermal conductivity and adhesiveness.

The resin layer contains at least one inorganic filler. Examples of a kind of an inorganic filler include an electrically nonconductive filler, such as aluminium oxide, magnesium oxide, aluminum nitride, boron nitride, silicon nitride, silicon oxide, aluminium hydroxide, and barium sulfate. Included further an electrically conductive filler, such as gold, silver, nickel, and copper, and among them copper is preferable. As an inorganic filler used according to the present invention aluminium oxide is more preferable. The inorganic fillers may be used singly or used in a combination of 2 or more types thereof.
By using an electrically nonconductive filler, a multilayer resin sheet with improved insulation can be obtained. While using an electrically conductive filler, a multilayer resin sheet with improved thermal conductivity can be obtained.

For the resin layer, a mixture of inorganic fillers with 2 or more different volume-averaged particle sizes is preferably used as the inorganic filler. In other words the particle size distribution curve of the inorganic filler shows preferably at least 2 peaks, and more preferably at least 3 peaks.
Owing to the above, into gaps in an inorganic filler with a larger particle size, an inorganic filler with a smaller particle size is packed, and therefore closer packing than in single use of an inorganic filler with a uniform particle size is possible, so that higher thermal conductivity can be attained.

In this regard, the particle size distribution, and the volume-averaged particle size of an inorganic filler are measured by laser diffractometry. The laser diffractometry can be conducted using a laser diffraction scattering particle size distribution analyzer (e.g. LS230 by Beckman Coulter, Inc.).

If the inorganic filler is a mixture of 2 or more inorganic fillers with different volume-averaged particle sizes, more specifically, for example, if aluminium oxide is used, by mixing in the total inorganic filler an inorganic filler with the volume-averaged particle size of 16 µm to 20 µm in a range of 60 to 75 % by mass, an inorganic filler with the volume-averaged particle size of 2 µm to 4 µm in 10 to 20 % by mass, and an inorganic filler with the volume-averaged particle size of 0.3 µm to 0.5 µm in 10 to 20 % by mass, closer-packing can be accomplished.

The content of an inorganic filler can be realized in a range of 1 to 99 % by mass based on the total mass of the resin layer as 100 % by mass; and it is preferably 50 to 97 % by mass, and more preferably 80 to 95 % by mass.
If the content of an inorganic filler is 50 % by mass or more, high thermal conductivity can be attained, and if it is 97 % by mass or less, decrease in flexibility or insulation of a resin sheet can be inhibited.

The resin layer preferably contains at least one binder agent, and more preferably contains a silane coupling agent as a binder agent. The contained binder agent (preferably a silane coupling agent) is believed to play a role to form covalent bonds between the surfaces of an inorganic filler and surrounding organic resins. They are believed to contribute to efficient thermal transmittance and improvement of the insulation reliability through functions of prevention of moisture infiltration.
There is no particular restriction on the content of a binder agent, and from an aspect of thermal conductivity, 0.01 to 2 % by mass is preferable, and 0.1 to 1 % by mass is more preferable.

As the silane coupling agent a commercial product can be used without any particular restriction. Considering the compatibility with an epoxy resin and a phenol resin and reduction of the loss in thermal conductance at an interface between a resin layer and an inorganic filler layer, the use of a silane coupling agent having at least one selected out of an epoxy group, an amino group, a mercapto group, a ureido group, and a hydroxy group at the terminal is preferable.

Specific examples include 3-glycidoxypropyltrimethoxysilane, 3-glycidoxypropyltriethoxysilane, 3-glycidoxypropylmethyldiethoxysilane, 3-glycidoxypropylmethyldimethoxysilane, 2-(3,4-epoxycyclohexyl)ethyltrimethoxysilane, 3-aminopropyltriethoxysilane, 3-(2-aminoethyl)aminopropyltrimethoxysilane, 3-(2-aminoethyl)aminopropyltrimethoxysilane, 3-aminopropyltrimethoxysilane, 3-phenylaminopropyltrimethoxysilane, 3-mercaptopropyltrimethoxysilane, 3-mercaptotriethoxysilane, and 3-ureidopropyltriethoxysilane.
Further, a silane coupling agent oligomer as represented by SC-6000KS2 (by Hitachi Chemical Coated Sand Co., Ltd.) can be utilized. The silane coupling agents may be used singly or used in a combination of 2 or more types thereof.

A resin layer (resin sheet) according to the present invention can be formed, for example, by applying a resin composition containing an epoxy resin having a mesogenic skeleton, a curing agent, and an inorganic filler, as well as, according to need, a solvent, on a release film followed by drying.
More specifically, for example, a resin composition in a varnish form added with a solvent, such as methyl ethyl ketone or cyclohexanone, is applied with an applicator on a release film such as a PET film, and the solvent is removed by drying to accomplish the resin layer.

The resin layer may be cured thermally or by light to a semi-cured B-stage (in this stage, for example, the viscosity at normal temperature (25°C) of 10⁴ to 10⁵ Pa·s decreases at 100°C to 10² to 10³ Pa·s). In this regard, for the thermal curing, a heat press is preferably used to planarize the resin sheet.
An example of a thermal curing method of the resin layer to a B-stage, is heat pressing at a temperature of 80°C to 150°C, and a pressure of 0.1 MPa to 4 MPa, for 0.1 min to 5 min.

There is no particular restriction on the density of the resin layer, and it depends on the inorganic filler content, it is usually 3.00 to 3.40 g/cm³. Considering the balance of the flexibility and the thermal conductivity of the resin layer, it is preferably 3.00 to 3.30 g/cm³, and more preferably a range of 3.10 to 3.30 g/cm³. The density can be measured by a conventional method based on the Archimedean method.

There is no particular restriction on the thickness of the resin layer, and it can be selected appropriately according to an object. From viewpoints of adhesiveness and thermal conductivity, it is preferably 35 µm to 250 µm, and more preferably 70 µm to 200 µm.

### <Method for producing multilayer resin sheet>

A method for producing a multilayer resin sheet according to the present invention is constituted by a resin layer formation step, in which a resin layer is yielded by forming a resin composition containing an epoxy resin having a mesogenic skeleton, a curing agent and an inorganic filler into a sheet, an adhesive layer formation step, in which an insulating adhesive layer is formed on at least either of the surfaces of the resin layer, and an additional step according to need.
The resin layer formation step and the adhesive layer formation step, together with their preferable embodiments, are as described above.

### <Method for producing cured multilayer resin sheet>

A method for producing a cured multilayer resin sheet according to the present invention is constituted by a curing step, in which the multilayer resin sheet is subjected to light or heat to cure the resin layer constituting a multilayer resin sheet, and an additional step according to need.

By applying light or heat to the resin layer, a resin developing a higher order structure (an epoxy resin having a mesogenic skeleton) and a curing agent react to form a higher order cross-linked structure composed of a crystalline structure part and a amorphous structure part. Further, the resin layer contains an inorganic filler and an insulating adhesive layer is provided on the resin layer. Consequently, the cured multilayer resin sheet has high thermal conductivity, good insulation and adhesive strength, and superior thermal shock resistance, and is suitable for an electric insulating material to be applied to electric and electronic devices.

For curing the resin layer is used light or heat. Examples of a means for applying light for curing the resin layer include a UV illuminator.

Examples of a method of applying heat for curing the resin layer, include a method using a heating temperature of 100 to 220°C for a heating duration of 30 min to 10 hours.
According to the present invention from an aspect of thermal conductivity, a heat treatment in a heating temperature range including a temperature, at which an epoxy resin having a mesogenic skeleton can easily align, is preferable. From an aspect of attaining high thermal conductivity, especially heating in at least 2 stages of not less than 100°C but less than 160°C, and not less than 160°C but less than 250°C is more preferable; and heating in at least 3 stages of not less than 100°C but less than 160°C, not less than 160°C but less than 180°C, and not less than 190°C but less than 250°C is further preferable.

### <Highly thermally conductive resin sheet laminate and method for producing the same>

A highly thermally conductive resin sheet laminate according to the present invention has the cured multilayer resin sheet and metal plates or radiator plates placed on both the surfaces of the cured multilayer resin sheet.
Such a highly thermally conductive resin sheet laminate has high thermal conductivity and is superior in thermal shock resistance; and the adhesive strength between a resin layer and a metal plate or a radiator plate is good.

Examples of a metal plate or a radiator plate include a copper plate, an aluminum plate, and a ceramic plate. In this regard, there is no particular restriction on the thickness of a metal plate or a radiator plate. Further, as a metal plate or a radiator plate, a metal foil, such as a copper foil and an aluminum foil, may be used.

The highly thermally conductive resin sheet laminate can be produced by a method for producing having a step for placing a metal plate or a radiator plate on an insulating adhesive layer of the multilayer resin sheet having insulating adhesive layers on both the surfaces of a resin layer, and a curing step, in which the multilayer resin sheet is subjected to light or heat to cure the resin layer.

As for a method for placing a metal plate or a radiator plate on an insulating adhesive layer of a multilayer resin sheet, a method generally applied can be applied without any particular restriction. An example of the method is bonding a metal plate or a radiator plate on to an insulating adhesive layer. Examples of a bonding method include a pressing method and a laminating method.
A method for curing a resin layer of the multilayer resin sheet, and a preferable embodiment thereof, are as described above.

Since a multilayer resin sheet according to the present invention is superior in electric insulation, thermal conductivity, and adhesiveness, it can be applied to various uses. For example, it is applicable favorably for constituting a power semiconductor device including a thyristor, an IGBT, and the like., or a photo-semiconductor device including an LED chip, and the like.

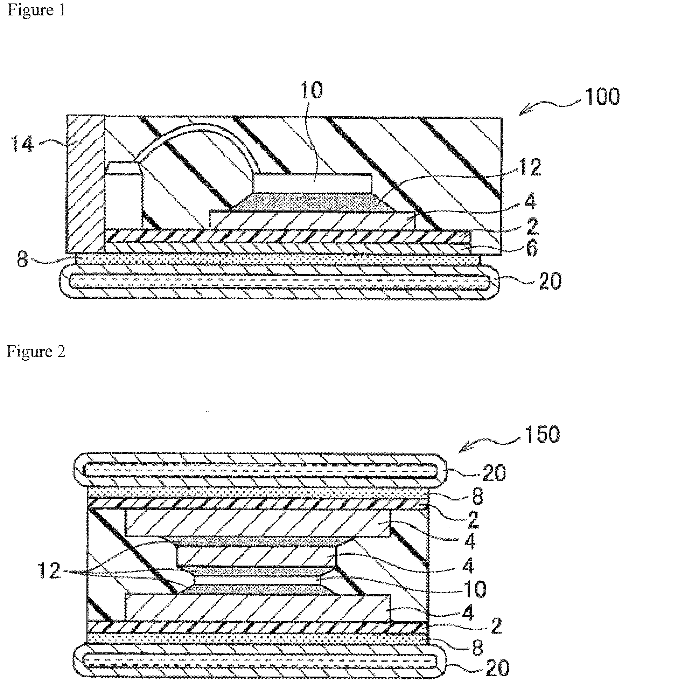

In Figure 1 to Figure 3, examples of a constitution of a power semiconductor device are shown.
Figure 1 is a schematic cross-sectional view showing an example of a constitution of a power semiconductor device 100 constituted by laminating a copper plate 4 provided with a power semiconductor chip 10 through the intermediary of a solder layer 12, a multilayer resin sheet 2 according to the present invention, and a radiating base 6 placed on a water-cooling jacket 20 through the intermediary of a grease layer 8. Since a heat generator including the power semiconductor chip 10 contacts a heat radiating member through the intermediary of the multilayer resin sheet according to the present invention, efficient heat radiation can be conducted. In this regard, the radiating base 6 can be constituted with thermally conductive copper or aluminium.

Figure 2 is a schematic cross-sectional view showing an example of a constitution of a power semiconductor device 150 constituted by placing cooling members on both surfaces of a power semiconductor chip 10. In the power semiconductor device 150, the cooling member placed on the upper surface of the power semiconductor chip 10 is constituted by including 2 layers of copper plates 4. Due to this constitution, occurrence of chip breakage or solder fracture can be inhibited more effectively. In Figure 2 the multilayer resin sheet 2 and the water-cooling jacket 20 are arranged through the intermediary of the grease layer 8, but the multilayer resin sheet 2 and the water-cooling jacket 20 may be arranged so as to allow direct contact between them.

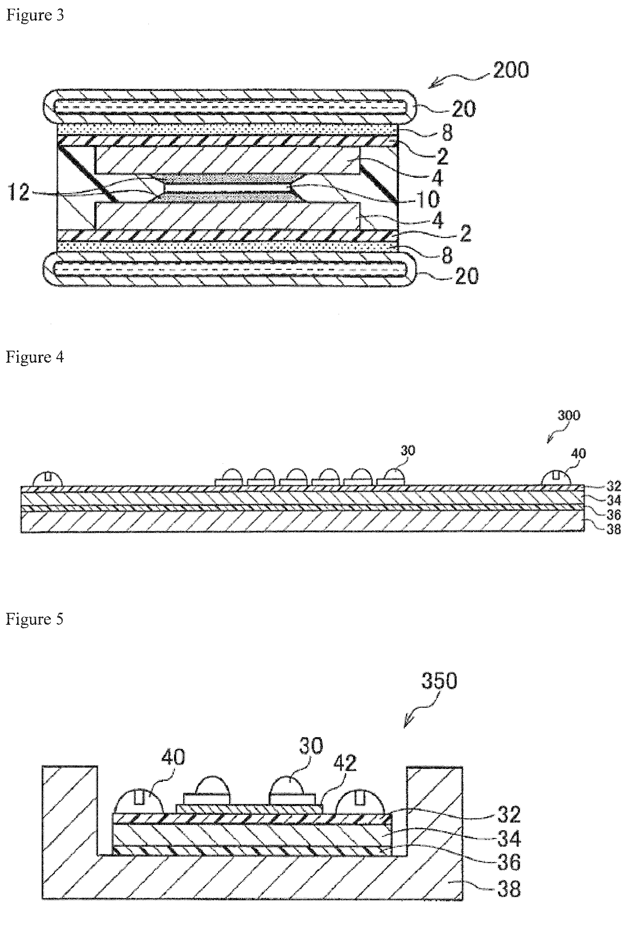

Figure 3 is a schematic cross-sectional view showing an example of a constitution of a power semiconductor device 200 constituted by placing cooling members on both surfaces of a power semiconductor chip 10. In the power semiconductor device 200, the cooling member placed on both the surfaces of the power semiconductor chip 10 are constituted by each including 1 layer of copper plates 4. In Figure 3 the multilayer resin sheet 2 and the water-cooling jacket 20 are arranged through the intermediary of the grease layer 8, but the multilayer resin sheet 2 and the water-cooling jacket 20 may be arranged so as to allow direct contact between them.

Figure 4 is a schematic cross-sectional view showing an example of a constitution of an LED light bar 300. The LED light bar 300 is constituted by arranging a housing 38, a grease layer 36, an aluminum substrate 34, a multilayer resin sheet 32 according to the present invention, and LED chips 30 in the order mentioned. By placing heat generators, namely the LED chips 30, on the aluminum substrate 34 through the intermediary of the multilayer resin sheet 32 according to the present invention, heat radiation can be conducted efficiently.

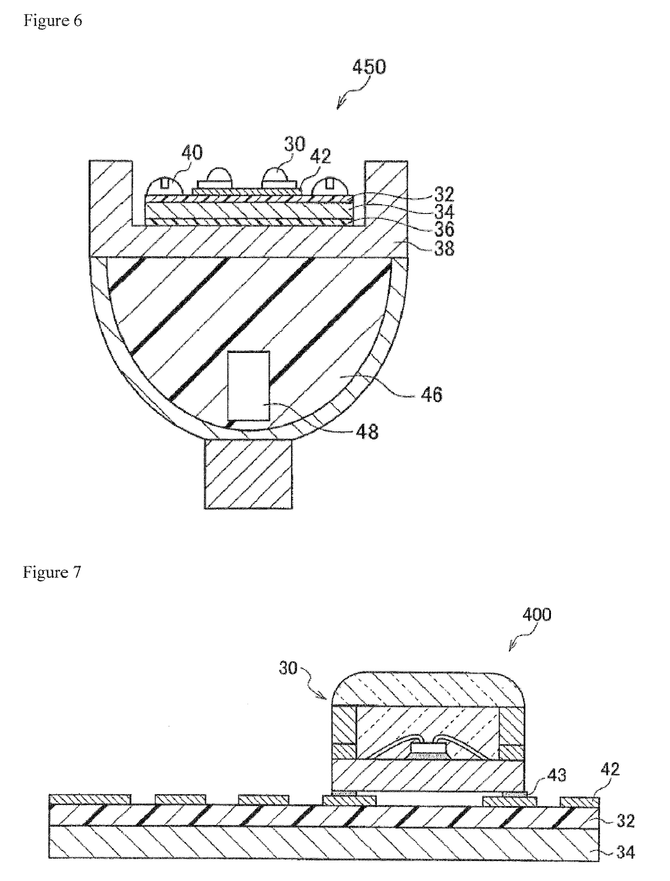

Figure 5 is a schematic cross-sectional view showing an example of a constitution of a light emitting section 350 of an LED bulb. The light emitting section 350 of the LED bulb is constituted by arranging a housing 38, a grease layer 36, an aluminum substrate 34, a multilayer resin sheet 32 according to the present invention, a circuit layer 42 and LED chips 30 in the order mentioned.
Further, Figure 6 is a schematic cross-sectional view showing an example of an overall constitution of an LED bulb 450.

Figure 7 is a schematic cross-sectional view showing an example of a constitution of an LED substrate 400. The LED substrate 400 is constituted by arranging an aluminium substrate 34, a multilayer resin sheet 32 according to the present invention, a circuit layer 42, and an LED chip 30 in the order mentioned. By placing heat a generator, namely the LED chip 30, on the aluminium substrate 34 through the intermediary of the circuit layer and the multilayer resin sheet 32 according to the present invention, heat radiation can be conducted efficiently.

The disclosures of Japanese Patent Application No. 2009-224333 are incorporated by reference herein in their entireties.
All the literature, patent applications, and technical standards cited herein are also herein incorporated to the same extent as provided for specifically and severally with respect to an individual literature, patent application, and technical standard to the effect that the same should be so incorporated by reference.

### [Examples]

Specific examples of the present invention will be described below, provided that the present invention be not limited thereto.

### (Production example 1: Method for producing resin sheet 1)

As an inorganic filler: aluminium oxide [α-alumina by Sumitomo Chemical Co., Ltd.: aluminium oxide with the average particle size of 18 µm (AA-18) 166.80 parts by mass, aluminium oxide with the average particle size of 3 µm (AA-3) 31.56 parts by mass, and aluminium oxide with the average particle size of 0.4 µm (AA-04) 27.05 parts by mass] 225.41 parts by mass,
as a silane coupling agent: 3-phenylaminopropyltrimethoxysilane (KBM-573, by Shin-Etsu Chemical Co., Ltd.) 0.24 parts by mass,
as a curing agent: a catechol resorcinol novolac (CRN) resin dissolved in cyclohexanone (solid content 50 % by mass, by Hitachi Chemical Co., Ltd.) 11.67 parts by mass, methyl ethyl ketone (MEK) 37.61 parts by mass, and cyclohexanone (CHN) 6.70 parts by mass, as well as alumina balls (particle size 3 mm) 300 parts by mass were mixed in a ball mill.
After confirming that they were mixed uniformly, as an epoxy resin having a mesogenic skeleton (highly thermally conductive epoxy resin), 18.04 parts by mass of 1-{(3-methyl-4-oxiranylmethoxy)phenyl}-4-(4-oxiranylmethoxyphenyl)-1-cyclohexene (epoxy resin) synthesized according to the description in Japanese Patent Laid-Open No. 2005-206814 and 0.19 part by mass of triphenylphosphine (TPP) (Wako Pure Chemical Industries, Ltd.) were mixed therein and ball-milling was continued for 40 to 60 hours to obtain a resin composition in a varnish form (resin sheet coating liquid).

The resin sheet coating liquid (resin composition) was applied by an applicator on to a releasing surface of a polyethylene terephthalate film (75E-0010CTR-4, by Fujimori Kogyo Co., Ltd.; hereinafter occasionally abbreviated simply as "PET film") to the thickness of approx. 300 µm and left standing at a normal condition for 10 to 15 min, followed by drying in a box-type oven set at 100°C for 30 min, and the the upper surface exposed to air was covered by a PET film. The assembly was heat-pressed (heat plate 130°C; pressure 1 MPa; press time 1 min) for planarization, to obtain a 200 µm-thick resin sheet in the B-stage (resin sheet 1). The density of the obtained resin sheet 1 (resin layer) was 3.20 g/cm³.

### (Production example 1-2: Method for producing resin sheet 2)

Identically with Production example 1 except that 4,4'-biphenol diglycidyl ether (by Mitsubishi Chemical Corporation) was used as an epoxy resin having a mesogenic skeleton (highly thermally conductive epoxy resin) referred to in Production example 1, a resin composition in a varnish form (resin sheet coating liquid) was produced to obtain a resin sheet in the B-stage (resin sheet 2). The density of the obtained resin sheet 2 (resin layer) was 3.20 g/cm³.

### (Production example 1-3: Method for producing resin sheet 3)

Identically with Production example 1 except that 2,6-bis[4-[4-[2-(oxiranylmethoxy)ethoxy]phenyl]phenoxy]pyridine synthesized according to Japanese Patent Laid-Open No. 2005-29788 was used as an epoxy resin having a mesogenic skeleton (highly thermally conductive epoxy resin) referred to in Production example 1, a resin composition in a varnish form (resin sheet coating liquid) was produced to obtain a resin sheet in the B-stage (resin sheet 3). The density of the obtained resin sheet 3 (resin layer) was 3.20 g/cm³.

### (Production example 1-4: Method for producing resin sheet 4)

Using 4-(oxiranylmethoxy)benzoic acid-4,4'-[1,8-octanediylbis(oxy)]bisphenol ester synthesized according to the description in J. Polym. Sci., Part A: Polym. Chem., Vol. 34, 1291-1303 (1996) as an epoxy resin having a mesogenic skeleton (highly thermally conductive epoxy resin) referred to in Production example 1, a resin composition in a varnish form (resin sheet coating liquid) was produced to obtain a sheet in the B-stage (resin sheet 4). The density of the obtained resin sheet 4 (resin layer) was 3.20 g/cm³.

### (Method for producing insulating adhesive layer 1)

A modified polyamide imide resin varnish (Grade name: KS6003; solid content: 40 % by mass; by Hitachi Chemical Co., Ltd.) was applied by a comma coater (by Hirano Tecseed Co. ,Ltd.) on a PET film treated with a release agent. The film was dried for 8 min in a conveyor type drying oven set at 130 to 140°C to yield an insulating adhesive layer 1.
The film thickness was regulated by adjusting the gap between the comma coater and the polyethylene terephthalate film to obtain an insulating adhesive layer 1-1 (6 µm) and an insulating adhesive layer 1-2 (12 µm).

### (Method for producing insulating adhesive layer 2-1)

A modified polyamide imide resin varnish (Grade name: KS6003; solid content: 40 % by mass; by Hitachi Chemical Co., Ltd.) 12 parts by mass and an oxidized alumina filler (Grade name: TS-AP(LV)2; by Tatsumori Ltd.) 24 parts by mass were mixed and agitated in a blender (1400 rpm, 15 min) to obtain a varnish with the filler.
The varnish was applied by a comma coater on a PET film treated with a release agent, dried for 8 min in a conveyor type drying oven set at 130 to 140°C to yield an insulating adhesive layer 2-1 with the film thickness of 15 µm.

### (Method for producing insulating adhesive layer 2-2)

A modified polyamide imide resin varnish (Grade name: KS6003; solid content: 40 % by mass; by Hitachi Chemical Co., Ltd.) 9 parts by mass and an oxidized alumina filler (Grade name: TS-AP(LV)2; by Tatsumori Ltd.) 28 parts by mass were mixed and agitated in a blender (1400 rpm, 15 min) to obtain a varnish with the filler.
The varnish was applied by a comma coater on a PET film treated with a release agent, dried for 8 min in a conveyor type drying oven set at 130 to 140°C to yield an insulating adhesive layer 2-2 with the film thickness of 15 µm.

### (Production example 2: Method for producing multilayer resin sheet)

From a resin sheet 1 produced according to the afore-described procedure (Production example 1), a PET film was removed and an insulating adhesive layer obtained as above was placed thereon contacting its surface opposite to the PET film with the surface of the resin sheet 1 exposed by removing the PET film, and laminated by a vacuum laminating machine (by Meiki Co., Ltd.) at a temperature 120°C, a pressure 1.0 MPa, degree of vacuum ≤1kPa, for 30 sec to attach an insulating adhesive layer to one surface or to both the surfaces, thereby completing a multilayer resin sheet.

### (Example 1)

According to the method for producing a multilayer resin sheet (Production example 2) insulating adhesive layers 1-1 were attached to both the surfaces of a resin sheet 1 to produce a multilayer resin sheet 1, in which a resin layer was in the B-stage.
Removing PET films from both the surfaces of the obtained multilayer resin sheet 1 and covering both the surfaces with 35 µm-thick copper foils (GTS foil, by Furukawa Electric Co., Ltd.), the sheet was subjected to vacuum heat pressing (heat plate temperature 150°C, degree of vacuum ≤1kPa, pressure 4 MPa, and processing time 10 min). Then it was cured stepwise in a box type oven at 140°C for 2 hours, at 165°C for 2 hours, and at 190°C for 2 hours, to obtain a highly thermally conductive resin sheet laminate 1 (sample).
The sample was subjected to a reflow treatment (300°C, 5 min). A delamination phenomenon at the interface between the resin sheet and the copper foil was not observed. From the obtained highly thermally conductive resin sheet laminate 1, only copper was removed by etching with a sodium persulfate solution to obtain a naked cured multilayer resin sheet. The thermal conductivity was measured by a xenon flash lamp method to find the thermal conductivity oaf 6.2 W/mK. The insulation breakdown voltage was 5.0 kV. In this regard, the insulation breakdown voltage was measured according to the method of JIS C2110 (hereinafter the evaluation was conducted identically).

### (Example 2)

According to the above Method for producing multilayer resin sheet (Production example 2), a multilayer resin sheet 2, in which a resin layer was in the B-stage, was obtained by attaching insulating adhesive layers 1-2 on to both the surfaces of a resin sheet 1.
Removing PET films from both the surfaces of the obtained multilayer resin sheet 2 and covering both the surfaces with 35 µm-thick copper foils (GTS foil, by Furukawa Electric Co., Ltd.), the sheet was subjected to vacuum heat pressing (heat plate temperature 150°C, degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a highly thermally conductive resin sheet laminate 2 (sample).
The sample was subjected to a reflow treatment (300°C, 5 min). A delamination phenomenon at the interface between the resin sheet and the copper foil was not observed. From the obtained highly thermally conductive resin sheet laminate 2, only copper was removed by and the likehing with a sodium persulfate solution to obtain a naked cured multilayer resin sheet. The thermal conductivity was measured by a xenon flash lamp method to find the thermal conductivity of 5.2 W/mK. The insulation breakdown voltage was 6.0 kV.

### (Example 3)

According to the above Method for producing multilayer resin sheet (Production example 2), a multilayer resin sheet 3, in which a resin layer was in the B-stage, was obtained by attaching insulating adhesive layers 2-1 on to both the surfaces of a resin sheet 1.
Removing PET films from both the surfaces of the obtained multilayer resin sheet 3 and covering both the surfaces with 35 µm-thick copper foils (GTS foil, by Furukawa Electric Co., Ltd.), the sheet was subjected to vacuum heat pressing (heat plate temperature 150°C, degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a highly thermally conductive resin sheet laminate 3 (sample).
The sample was subjected to a reflow treatment (300°C, 5 min). A delamination phenomenon at the interface between the resin sheet and the copper foil was not observed. From the obtained highly thermally conductive resin sheet laminate 3, only copper was removed by and the likehing with a sodium persulfate solution to obtain a naked cured multilayer resin sheet. The thermal conductivity was measured by a xenon flash lamp method to find the thermal conductivity of 8.3 W/mK. The insulation breakdown voltage was 4.3 kV.

### (Example 4)

According to the above Method for producing multilayer resin sheet (Production example 2), a multilayer resin sheet 4, in which a resin layer was in the B-stage, was obtained by attaching insulating adhesive layers 2-2 on to both the surfaces of a resin sheet 1.
Removing PET films from both the surfaces of the obtained multilayer resin sheet 4 and covering both the surfaces with 35 µm-thick copper foils (GTS foil, by Furukawa Electric Co., Ltd.), the sheet was subjected to vacuum heat pressing (heat plate temperature 150°C, degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a highly thermally conductive resin sheet laminate 4 (sample).
The sample was subjected to a reflow treatment (300°C, 5 min). A delamination phenomenon at the interface between the resin sheet and the copper foil was not observed. From the obtained highly thermally conductive resin sheet laminate 4, only copper was removed by and the likehing with a sodium persulfate solution to obtain a naked cured multilayer resin sheet. The thermal conductivity was measured by a xenon flash lamp method to find the thermal conductivity of 9.1 W/mK. The insulation breakdown voltage was 3.5 kV.

### (Example 5)

According to the above Method for producing multilayer resin sheet (Production example 2), a multilayer resin sheet 5, in which a resin layer was in the B-stage, was obtained by attaching an insulating adhesive layer 1-2 on to one surface of a resin sheet 1.
Removing PET films from both the surfaces of the obtained multilayer resin sheet 5 and covering both the surfaces with 35 µm-thick copper foils (GTS foil, by Furukawa Electric Co., Ltd.), the sheet was subjected to vacuum heat pressing (heat plate temperature 150°C, degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a highly thermally conductive resin sheet laminate 5.
The sample was subjected to a reflow treatment (300°C, 5 min). As the result, a delamination phenomenon at the interface between the resin sheet and the copper foil in the magnitude of approx. 30% of the area was recognized according to observation of an ultrasonic flaw detection image. From the obtained highly thermally conductive resin sheet laminate 5, only copper was removed by and the likehing with a sodium persulfate solution to obtain a naked cured multilayer resin sheet. The thermal conductivity was measured by a xenon flash lamp method to find the thermal conductivity of 6.1 W/mK. The insulation breakdown voltage was 4.5 kV.

### (Example 6)

According to the above Method for producing multilayer resin sheet (Production example 2), a multilayer resin sheet 6, in which a resin layer was in the B-stage, was obtained by attaching an insulating adhesive layer 2-1 on to one surface of a resin sheet 1.
Removing PET films from both the surfaces of the obtained multilayer resin sheet 6 and covering both the surfaces with 35 µm-thick copper foils (GTS foil, by Furukawa Electric Co., Ltd.), the sheet was subjected to vacuum heat pressing (heat plate temperature 150°C, degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a highly thermally conductive resin sheet laminate 6.
The sample was subjected to a reflow treatment (300°C, 5 min). As the result, a delamination phenomenon at the interface between the resin sheet and the copper foil in the magnitude of approx. 50% of the area was recognized according to observation of an ultrasonic flaw detection image. From the obtained highly thermally conductive resin sheet laminate, only copper was removed by and the likehing with a sodium persulfate solution to obtain a naked cured multilayer resin sheet. The thermal conductivity was measured by a xenon flash lamp method to find the thermal conductivity of 8.7 W/mK. The insulation breakdown voltage was 3.4 kV.

### (Comparative Example 1)

Removing PET films from both the surfaces of the resin sheet 1 produced according to the aforedescribed "Method for producing resin sheet (Production example 1)" and covering both the surfaces with 35 µm-thick copper foils (GTS foil, by Furukawa Electric Co., Ltd.), the sheet was subjected to vacuum heat pressing (heat plate temperature 150°C. degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a resin sheet laminate C 1.
The sample was subjected to a reflow treatment (300°C, 5 min). As the result, a delamination phenomenon at the interface between the resin sheet and the copper foil was observed. From the obtained resin sheet laminate C1, only copper was removed by and the likehing with a sodium persulfate solution to obtain a naked cured resin sheet. The thermal conductivity was measured by a xenon flash lamp method to find the thermal conductivity of 10.0 W/mK. The insulation breakdown voltage was 2.5 kV.

### (Comparative Example 2)

Except that in place of an epoxy resin having a mesogenic skeleton (highly thermally conductive epoxy resin) in the aforedescribed method for producing resin sheet 1 (Production example 1) a commercially supplied bisphenol A epoxy resin (Trade name: YDF8170C, by Nippon Steel Chemical Co., Ltd.) was used as an epoxy resin, a sheet in the B-stage (comparative resin sheet) was produced according to the same procedure.
Removing PET films from both the surfaces of the sheet in the B-stage (comparative resin sheet) and covering both the surfaces with 35 µm-thick copper foils (GTS foil, by Furukawa Electric Co., Ltd.), the sheet was subjected to vacuum heat pressing (heat plate temperature 150°C, degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a resin sheet laminate C2.
The sample was subjected to a reflow treatment (300°C, 5 min). As the result, a delamination phenomenon at the interface between the resin sheet and the copper foil was observed. From the obtained resin sheet laminate C2, only copper was removed by and the likehing with a sodium persulfate solution to obtain a naked cured resin sheet. The thermal conductivity was measured by a xenon flash lamp method to find the thermal conductivity of 5.3 W/mK. The insulation breakdown voltage was 2.5 kV.

### (Comparative Example 3)

By attaching insulating adhesive layers 2-1 to both the surfaces of the comparative resin sheet produced in Comparative Example 1, a sheet in the B-stage (comparative multilayer resin sheet) was obtained.
Removing PET films from both the surfaces of the sheet in the B-stage (comparative multilayer resin sheet) and covering both the surfaces with 35 µm-thick copper foils (GTS foil, by Furukawa Electric Co., Ltd.), the sheet was subjected to vacuum heat pressing (heat plate temperature 150°C, degree of vacuum ≤1 kPa, pressure 4 MPa, and processing time 10 min). Then it was cured stepwise in a box type oven at 140°C for 2 hours, at 165°C for 2 hours, and at 190°C for 2 hours, to obtain a resin sheet laminate C3.
The sample was subjected to a reflow treatment (300°C, 5 min). As the result, a delamination phenomenon at the interface between the resin sheet and the copper foil was not observed. From the obtained resin sheet laminate C3, only copper was removed by and the likehing with a sodium persulfate solution to obtain a naked cured multilayer resin sheet. The thermal conductivity was measured by a xenon flash lamp method to find the thermal conductivity of 3.5 W/mK. The insulation breakdown voltage was 4.2 kV.

### (Examples 7 to 12)

Except that the resin sheet 2 obtained in Production example 1-2 was used, identically with Examples 1 to 6 an insulating adhesive layer(s) were placed on one surface or both the surfaces of the resin sheet 2 to form a constitution shown in Table 2 to obtain multilayer resin sheets 7 to 12.
Identically as described above, except that the thus obtained multilayer resin sheet was used, a highly thermally conductive resin sheet laminate was prepared and the identical evaluations were conducted. The results are shown in Table 2.

### (Comparative Example 4)

Except that the resin sheet 2 obtained in Production example 1-2 was used, identically with Comparative Example 1 a resin sheet laminate C4 was prepared and the identical evaluations were conducted. The results are shown in Table 2.

### (Examples 13 to 18)

Except that the resin sheet 3 obtained in Production example 1-3 was used, identically with Examples 1 to 6 an insulating adhesive layer(s) were placed on one surface or both the surfaces of the resin sheet 3 to form a constitution shown in Table 3 to obtain multilayer resin sheets 13 to 18.
Identically as described above, except that an obtained multilayer resin sheet was used, a highly thermally conductive resin sheet laminate was prepared and the identical evaluations were conducted. The results are shown in Table 3.

### (Comparative Example 5)

Except that the resin sheet 3 obtained in Production example 1-3 was used, identically with Comparative Example 1 a resin sheet laminate C5 was prepared and the identical evaluations were conducted. The results are shown in Table 3.

### (Examples 19 to 24)

Except that the resin sheet 4 obtained in Production example 1-4 was used, identically with Examples 1 to 6 an insulating adhesive layer(s) were placed on one surface or both the surfaces of the resin sheet 4 to form a constitution shown in Table 4 to obtain multilayer resin sheets 19 to 24.
Identically as described above, except that an obtained multilayer resin sheet was used, a highly thermally conductive resin sheet laminate was prepared and the identical evaluations were conducted. The results are shown in Table 4.

### (Comparative Example 6)

Except that the resin sheet 4 obtained in Production example 1-4 was used, identically with Comparative Example 1 a resin sheet laminate C6 was prepared and the identical evaluations were conducted. The results are shown in Table 4.

**[Table 1]**

| | | Example 1 | Example 2 | Example 3 | Example 4 | Example 5 | Example 6 | Comparative Example 1 | Comparative Example 2 | Comparative Example 3 |
|---|---|---|---|---|---|---|---|---|---|---|
| Resin Layer | AA-18 | 166.80 | 166 80 | 166.80 | 166 80 | 166 80 | 166 80 | 166 80 | 166.80 | 166 80 |
| | AA-3 | 31 56 | 31.56 | 31.56 | 31.56 | 31.56 | 31.56 | 31. 56 | 31. 56 | 31 56 |
| | AA-04 | 27 05 | 27. 05 | 27.05 | 27.05 | 27. 05 | 27 05 | 27.05 | 27.05 | 27 05 |
| | KBM573 | 0 24 | 0.24 | 0.24 | 0.24 | 0 24 | 0.24 | 0.24 | 0.24 | 0.24 |
| | CRN resin | 11.67 | 11 67 | 11 67 | 11 67 | 11 67 | 11.67 | 11.67 | 11.67 | 11 67 |
| | MEK | 37 61 | 37.61 | 37 61 | 37. 61 | 37. 61 | 37.61 | 37. 61 | 37.61 | 37 61 |
| | CHN | 6 70 | 6 70 | 6 70 | 6 70 | 6.70 | 6.70 | 6 70 | 6 70 | 6 70 |
| | Epoxy rein having a mesogenic skeleton | 18.04 | 18.04 | 18.04 | 18 04 | 18. 04 | 18 04 | 18.04 | - | - |
| | Bisphonel A type epoxy resin | - | - | - | - | - | - | - | 18.04 | 18 04 |
| | TPP | 0 19 | 0 19 | 0 19 | 0 19 | 0 19 | 0.19 | 0 19 | 0 19 | 0.19 |
| Insulating adhesive Layer *¹⁾ | 1-1 (both surfaces) | ○ | - | - | - | - | - | - | - | - |
| | 1-2 (both surfaces) | - | ○ | - | - | - | - | - | - | - |
| | 2-1 (both surfaces) | - | - | ○ | - | - | - | - | - | ○ |
| | 2-2 (both surfaces) | - | - | - | ○ | - | - | - | - | - |
| | 1-2 (one surface) | - | - | - | - | ○ | - | - | - | - |
| | 2-1 (one surface) | - | - | - | - | - | ○ | - | - | - |
| thermal conductivity (W/mK) | | 6 2 | 5.2 | 8.3 | 9.1 | 6.1 | 8. 7 | 10.0 | 5.3 | 3 5 |
| insulation breakdown voltage (kV) | | 5.0 | 6.0 | 4.3 | 3.5 | 4.5 | 3.4 | 2.5 | 2.5 | 4 2 |
| reflow resistance *²⁾ | | ○ | ○ | ○ | ○ | △ | △ | × | x | ○ |

| | | | | | | | | | | |
|---|---|---|---|---|---|---|---|---|---|---|
| (Compositon unit part by mass) | | | | | | | | | | |

Epoxy resin having a mesogenic skeleton:
1-{(3-methyl-4-oxiranylmethoxy)phenyl}-4-(4-oxiranylmethoxyphenyl)-1-cyclohexene Bisphenol A epoxy resin : YDF8170C (Nippon Steel Chemical Co., Ltd.).
   1)
      -: Without the corresponding insulating adhesive layer;
      o: With the corresponding insulating adhesive layer;
   2) Reflow resistance evaluation criteria
      ×: Delaminated more than 90% after treatment at 300°C, 5 min;
      Δ: Delaminated 10% to 90% after treatment at 300°C, 5 min;
      o: Delaminated less than 10% after treatment at 300°C, 5 min.

| | | Example 7 | Example 8 | Example 9 | Example 10 | Example 11 | Example 12 | Comparative Example 4 |
|---|---|---|---|---|---|---|---|---|
| Resin Layer | AA-18 | 166.80 | 166.80 | 166.80 | 166.80 | 166.80 | 166.80 | 166 80 |
| | AA-3 | 31.56 | 31.56 | 31.56 | 31.56 | 31.56 | 31.56 | 31.56 |
| | AA-04 | 27.05 | 21.05 | 27.05 | 27.05 | 27.05 | 27.05 | 27.05 |
| | KBM573 | 0.24 | 0.24 | 0.24 | 0.24 | 0.24 | 0.24 | 0.24 |
| | CRN resin | 11. 67 | 11.67 | 11.67 | 11.67 | 11.67 | 11.67 | 11.67 |
| | MEK | 37.61 | 37.61 | 37.61 | 37.61 | 37.61 | 37.61 | 37.61 |
| | CHN | 6 70 | 6.70 | 6.70 | 6.70 | 6.70 | 6.70 | 6.70 |
| | Epoxy rein having a mesogenic skeleton | 18.04 | 18.04 | 18.04 | 18.04 | 18.04 | 18.04 | 18.04 |
| | TPP | 0.19 | 0.19 | 0.19 | 0.19 | 0.19 | 0.19 | 0.19 |
| Insulating adhesive Layer *¹⁾ | 1-1 (both surfaces) | O | - | - | - | - | - | - |
| | 1-2 (both surfaces) | - | O | - | - | - | - | - |
| | 2-1 (both surfaces) | - | - | O | - | - | - | - |
| | 2-2 (both surfaces) | - | - | - | O | - | - | - |
| | 1-2 (one surface) | - | - | - | - | O | - | - |
| | 2-1 (one surface) | - | - | - | - | - | O | - |
| thermal conductivity (W/mK) | | 5.6 | 5.0 | 6.0 | 6.5 | 5.5 | 6.2 | 7.0 |
| insulation breakdown voltage (kV) | | 6.0 | 7.0 | 5.3 | 4.5 | 5.5 | 4.4 | 2.5 |
| reflow resistance *²⁾ | | O | O | O | O | Δ | Δ | × |

| | | | | | | | | |
|---|---|---|---|---|---|---|---|---|
| (Compositon unit part by mass) | | | | | | | | |

Epoxy resin having a mesogenic skeleton: 4,4'-biphenolglycidyl ether.
1)
   -: Without the corresponding insulating adhesive layer;
   o: With the corresponding insulating adhesive layer.
2) Reflow resistance evaluation criteria
   ×: Delaminated more than 90% after treatment at 300°C, 5 min;
   Δ: Delaminated 10% to 90% after treatment at 300°C, 5 min;
   o: Delaminated less than 10% after treatment at 300°C, 5 min.

| | | Example 13 | Example 14 | Example 15 | Example 16 | Example 17 | Example 18 | Comparative Example 5 |
|---|---|---|---|---|---|---|---|---|
| Resin Layer | AA-18 | 166.80 | 166 80 | 166 80 | 166 80 | 166 80 | 166 80 | 166 80 |
| | AA-3 | 31 56 | 31. 56 | 31. 56 | 31 56 | 31.56 | 31. 56 | 31. 56 |
| | AA-04 | 27 05 | 27 05 | 27 05 | 27 05 | 27 05 | 27. 05 | 27. 05 |
| | KBM573 | 0 24 | 0. 24 | 0. 24 | 0. 24 | 0. 24 | 0 24 | 0. 24 |
| | CRN resin | 11 67 | 11. 67 | 11 67 | 11 67 | 11. 67 | 11.67 | 11. 67 |
| | MEK | 37. 61 | 37. 61 | 37. 61 | 37 61 | 37. 61 | 37. 61 | 37. 61 |
| | CHN | 6 70 | 6. 70 | 6. 70 | 6 70 | 6 70 | 6 70 | 6 70 |
| | Epoxy rein having a mesogenic skeleton | 18 04 | 18. 04 | 18. 04 | 18 04 | 18. 04 | 18 04 | 18. 04 |
| | TPP | 0. 19 | 0. 19 | 0 19 | 0. 19 | 0 19 | 0 19 | 0 19 |
| Insulating adhesive Layer *¹⁾ | 1-1 (both surfaces) | O | - | - | - | - | - | - |
| | 1-2 (both surfaces) | - | O | - | - | - | - | - |
| | 2-1 (both surfaces) | - | - | O | - | - | - | - |
| | 2-2 (both surfaces) | - | - | - | O | - | - | - |
| | 1-2 (one surface) | - | - | - | - | O | - | - |
| | 2-1 (one surface) | - | - | - | - | - | O | - |
| thermal conductivity (W/mK) | | 9 0 | 8 5 | 10 5 | 12 0 | 9 5 | 11 0 | 13 0 |
| insulation breakdown voltage (kV) | | 5. 0 | 6. 0 | 4. 4 | 3 6 | 4. 5 | 3 7 | 2. 5 |
| reflow resistance *²⁾ | | O | O | O | O | Δ | Δ | × |

| | | | | | | | | |
|---|---|---|---|---|---|---|---|---|
| (Compositon unit part by mass) | | | | | | | | |

Epoxy resin having a mesogenic skeleton:
2,6-bis[4-[4-[2-(oxiranylmethoxy)ethoxy]phenyl]phenoxy]pyridine.
   1)
      -: Without the corresponding insulating adhesive layer;
      o: With the corresponding insulating adhesive layer.
   2) Reflow resistance evaluation criteria
      ×: Delaminated more than 90% after treatment at 300°C, 5 min;
      Δ: Delaminated 10% to 90% after treatment at 300°C, 5 min;
      o: Delaminated less than 10% after treatment at 300°C, 5 min.

| | | Example 19 | Example 20 | Example 21 | Example 22 | Example 23 | Example 24 | Comparative Examples 6 |
|---|---|---|---|---|---|---|---|---|
| Resin Layer | AA-18 | 166.80 | 166.80 | 166.80 | 166.80 | 166.80 | 166.80 | 166.80 |
| | AA-3 | 31.56 | 31.56 | 31.56 | 31.56 | 31.56 | 31.56 | 31.56 |
| | AA-04 | 27.05 | 27.05 | 27.05 | 27.05 | 27.05 | 27.05 | 27.05 |
| | KBM573 | 0.24 | 0.24 | 0.24 | 0.24 | 0.24 | 0.24 | 0.24 |
| | CRN resin | 11.67 | 11.67 | 11.67 | 11.67 | 11.67 | 11.67 | 11.67 |
| | MEK | 37.61 | 37.61 | 37. 61 | 37.61 | 37.61 | 37.61 | 37.61 |
| | CHN | 6.70 | 6.70 | 6.70 | 6.70 | 6.70 | 6.70 | 6.70 |
| | Epoxy rein having a mesogenic skeleton | 18.04 | 18.04 | 18.04 | 18.04 | 18.04 | 18.04 | 18.04 |
| | TPP | 0.19 | 0.19 | 0.19 | 0.19 | 0.19 | 0.19 | 0.19 |
| Insulating adhesive Layer*¹⁾ | 1-1 (both surfaces) | O | - | - | - | - | - | - |
| | 1-2 (both surfaces) | - | O | - | - | - | - | - |
| | 2-1 (both surfaces) | - | - | O | - | - | - | - |
| | 2-2 (both surfaces) | - | - | - | O | - | - | - |
| | 1-2 (one surface) | - | - | - | - | O | - | - |
| | 2-1 (one surface) | - | - | - | - | - | O | - |
| thermal conductivity (W/mK) | | 5. | 5.0 | 7.7 | 8.5 | 5.6 | 8.0 | 9.5 |
| insulation breakdown voltage (kV) | | 5.5 | 6.5 | 5.0 | 4.5 | 5.6 | 4.3 | 2. |
| reflow resistance *²⁾ | | O | O | O | O | A | Δ | × |

Epoxy resin having a mesogenic skeleton: 4-(oxiranylmethoxy)benzoic acid-4,4'-[1,8-octanediylbis(oxy)]bisphenol ester.
1)
   -: Without the corresponding insulating adhesive layer;
   o: With the corresponding insulating adhesive layer.
2) Reflow resistance evaluation criteria
   ×: Delaminated more than 90% after treatment at 300°C, 5 min;
   Δ: Delaminated 10% to 90% after treatment at 300°C, 5 min;
   o: Delaminated less than 10% after treatment at 300°C, 5 min.

From Table 1 is obvious that in Examples 1 to 4 using a multilayer resin sheet having insulating adhesive layers on both the surfaces, the thermal conductivity, the insulation breakdown strength, and the reflow resistance are good. While, in Examples 5 to 6 using a multilayer resin sheet having an insulating adhesive layer on only one surface, the thermal conductivity and the insulation breakdown strength were good, but the reflow resistance was found to be slightly inferior. Meanwhile, with respect to Comparative Example 1 using a resin sheet without an insulating adhesive layer, it was found that the thermal conductivity was good but the insulation breakdown strength was slightly low, and the reflow resistance was inferior. Further, as obvious with respect to Comparative Examples 2 to 3 using as an epoxy resin an epoxy resin other than an epoxy resin having a mesogenic skeleton, the thermal conductivity is lower compared to Examples.
Further, it was found from Table 2 through Table 4 that similar results as above could be obtained, even if as an epoxy resin having a mesogenic skeleton an epoxy resin having a mesogenic skeleton other than 1-{(3-methyl-4-oxiranylmethoxy)phenyl}-4-(4-oxiranylmethoxyphenyl)-1-cyclohexene was used

### [Industrial Applicability]

The present invention provides a highly thermally conductive resin composition having high thermal conductivity and being able to withstand a severe thermal shock on occasion of mounting or actual operation, and therefore expansion in a radiating material for an inverter of a hybrid car, a radiating material for an inverter of industrial devices, and a radiating material for an LED, which demands are anticipated to grow in future at an accelerated pace, can be expected.

### [Explanation of Letters or Numerals]

2 MULTILAYER RESIN SHEET
4 COPPER PLATE
6 RADIATING BASE
8 GREASE LAYER
10 POWER SEMICONDUCTOR CHIP
12 SOLDER LAYER
14 HOUSING
30 LED CHIP
32 MULTILAYER RESIN SHEET
34 ALUMINUM SUBSTRATE
36 GREASE LAYER
38 HOUSING (CHASSIS)
40 FIXING CLINCHER
42 CIRCUIT LAYER
43 SOLDER LAYER
46 ENCAPSULATION RESIN
48 POWER MEMBER
100 POWER SEMICONDUCTOR DEVICE
150 POWER SEMICONDUCTOR DEVICE
200 POWER SEMICONDUCTOR DEVICE
300 LED LIGHT BAR
350 LIGHT EMITTING SECTION
400 LED SUBSTRATE
450 LED BULB

## Claims

1. A multilayer resin sheet comprising a resin layer containing an epoxy resin having a mesogenic skeleton, a curing agent and an inorganic filler, and an insulating adhesive layer provided on at least one surface of the resin layer.

2. The multilayer resin sheet according to claim 1, wherein the insulating adhesive layer comprises at least one selected from the group consisting of a polyamide resin, a polyamide imide resin and a modified polyamide imide resin.

3. The multilayer resin sheet according to claim 1 or claim 2, wherein the insulating adhesive layer further comprises an inorganic filler.

4. The multilayer resin sheet according to any one of claim 1 to claim 3, wherein the curing agent is a phenolic novolac resin.

5. The multilayer resin sheet according to claim 4, wherein the phenolic novolac resin comprises a phenolic novolac resin linking, with a methylene chain, a phenolic compound selected from a monofunctional phenol and a bifunctional phenol.

6. The multilayer resin sheet according to claim 4, wherein the phenolic novolac resin comprises a catechol resorcinol novolac resin.

7. The multilayer resin sheet according to any one of claim 1 to claim 6, wherein the resin layer further comprises a binder agent.

8. The multilayer resin sheet according to claim 7, wherein the binder agent is a silane coupling agent.

9. A resin composition according to any one of claim 1 to claim 8, wherein a planar structure of the mesogenic skeleton has an asymmetric structure.

10. The multilayer resin sheet according to claim 9, wherein the mesogenic skeleton has a structure in which 2 bivalent functional groups derived from benzene are bonded through a bivalent linking group.

11. The multilayer resin sheet according to any one of claim 1 to claim 10, wherein a particle size distribution curve of the inorganic filler has at least 2 peaks.

12. The multilayer resin sheet according to any one of claim 1 to claim 11, wherein a density of the resin layer is from 3.00 to 3.30 g/cm³.

13. A highly thermally conductive resin sheet laminate comprising a cured multilayer resin sheet obtained by curing the multilayer resin sheet according to any one of claim 1 to claim 12, and metal plates or radiator plates placed on both surfaces of the cured multilayer resin sheet.

14. A method for producing a multilayer resin sheet comprising forming a resin layer which is yielded by forming a resin composition containing an epoxy resin having a mesogenic skeleton, a curing agent and an inorganic filler into a sheet, and forming an insulating adhesive layer which is provided on at least one surface of the resin layer.

15. A method for producing a cured multilayer resin sheet comprising a curing step, in which the multilayer resin sheet according to any one of claim 1 to claim 12 is subjected to light or heat to cure the resin layer.

16. A method for producing a highly thermally conductive resin sheet laminate comprising placing a metal plate or a radiator plate on the insulating adhesive layer of the multilayer resin sheet according to any one of claim 1 to claim 12, and curing the resin layer by subjecting the multilayer resin sheet to light or heat.
